# EUROPEAN PATENT APPLICATION

(11) **EP 3 588 587 A1**
(43) Date of publication of application: **01.01.2020**
(21) Application number: 18192028.1
(22) Date of filing: 31.08.2018
(51) Int. Cl.: H01L 31/18

(54) **LIGHT TRANSMISSION PROCESSING SYSTEM AND METHOD FOR SOLAR CHIP MODULE**

(30) Priority: 27.06.2018 CN 201810678615; 27.06.2018 CN 201810679387
(71) Applicant: Beijing Apollo Ding Rong Solar Technology Co., Ltd., Beijing 100176 (CN)
(72) Inventor: SHI, Qingwen, Beijing, Beijing 100176 (CN); GAO, Junzhao, Beijing, Beijing 100176 (CN); LIN, Jian, Beijing, Beijing 100176 (CN); SU, Qingfeng, Beijing, Beijing 100176 (CN); LIN, Junrong, Beijing, Beijing 100176 (CN); WANG, Hong, Beijing, Beijing 100176 (CN); JIANG, Wei, Beijing, Beijing 100176 (CN); LV, Hejiang, Beijing, Beijing 100176 (CN); SHA, Zhenhua, Beijing, Beijing 100176 (CN); WEI, Yao, Beijing, Beijing 100176 (CN); FENG, Jun, Beijing, Beijing 100176 (CN)
(74) Representative: Cohausz & Florack

(57) **Abstract**

The present disclosure provides a li ght transmission processing system and method for a solar chip module. The light transmission processing system includes: an ink printing unit (10) configured to print a preset pattern on an upper surface of the chip module with a UV ink so that a hollowed out region (108) is formed on an area of the upper surface of the chip module not covered by the pattern, the chip module including a transparent substrate (101) and a chip layer (100) superposed on the tr ansparent substrate; a curing unit (20) configured to cure the UV ink printed on the chip module to form a UV ink protective film (105'); and a layer removing unit (30) configured to remove a portion of the chip layer corresponding to the hollowed out region, to expose a portion of the transparent substrate corresponding to the hollowed out region.

## Description

### CROSS-REFERENCE TO RELATED APPLICATION

This application claims priority to Chinese patent applications No. 201810679387.6 and No. 201810678615.8 filed with the China Intellectual Property Office on June 27, 2018, the entire contents of wh ich are hereby incorporated by reference.

### TECHNICAL FIELD

The present disclosure relates to th e field of solar photovoltaic power generation, and particularly relates to a light transmission processing system and method for a solar chip module.

### BACKGROUND

Solar power generation system, al so known as photovoltaic power generation system, is a system that uses solar cells to generate a DC voltage through photovoltaic effect, converts solar radiation energy into electrical energy, and thus generates electricity. With an increasing emphasis on energy conservation and environmental protection, solar power generation systems have gained more and more opportunities for development. Among them, with respect to the combined application of a solar power generation system and a building, there are the following two forms of solar power generation system: BAPV system (Building Attached Photovoltaic, a solar power system attached to a building) and BIPV system (Building In tegrated Photovoltaic, a solar power system integrated with a building). Si nce BIPV system itself may replace a building material such as a curtain wall or a roof, and it could integrate the solar power generation system into the building itself without affecting the function of house while ensuring a beautiful appearance of the building and improving an overall power generation efficiency of the system, the BIPV system has become more and more popular.

However, light transmissive solarchip modules currently employed in the BIPV system are typically prepared through a laser scribing process. This preparing process has the following disadvantages: the associated apparatus is expensive, the process is complicated and time consuming, and the obtained light transmission size is small, and due to a high irradiation temperature, a chip layer which does not need to be removed is likely to be damaged. In addition, the light transmissive solar chip module may also be prepared with a special transparent chip layer and a special electrode layer. However, this preparation process has the problems of high cost and poor light transmission effect of the obtained module. The disadvantages of the above preparation processes have affected development of the BIPV system and ot her technologies to which solar chip modules are applied.

### SUMMARY

The present disclosure has been accomplished to at least partially solve the problems in related art. The present disclosure provides a light transmission processing system and method for a solar chip module (also known as photovoltaic chip module).

According to a first aspect of the present disclosure, there is provided a light transmission processing system for processing light transmittance of a solar chip module, the light transmission processing system comprising:
an ink printing unit configured to print a preset pattern on an upper surface of the solar chip module with ultraviolet (UV) ink, so that a UV ink layer is formed on an area of the upper surface of the so lar chip module covered by the pattern, and a hollowed out region is formed on an area of the upper surface of the solar chip module not covered by the pattern, wherein the solar chip module comprises a transparent substrate and a chip layer , and the chip layer is superposed on an upper surface of the transparent substrate ;
a curing unit configured to cure th e UV ink printed on the solar chip module with UV light to form a UV ink protective film ; and
a layer removing unit configured to remove a portion of the chip layer corresponding to the hollowed out region to expose a portion of the upper surface of the transparent substrate corresponding to the hollowed out region .

In an exemplary embodiment, the UV light ink refers to an ink containing a photopolymerization prepolym er, an initiator, a colorant, and an adjuvant.

In an exemplary embodiment, the UV light ink contains wear-resistant filler such as borax, bentonite, silica and the like.

In an exemplary embodiment, the light transmission processing system further comprises a transmission line, an d the transmission line is configured to transport the solar chip module through th e ink printing unit, the curing unit, and the layer removing unit sequentially.

In an exemplary embodiment, the layer removing unit comprises a sandblasting apparatus, and the sandblasting apparatus is configured to sandblast the upper surface of the so lar chip module on which the UV ink protective film is form ed to remove the porti on of the chip layer corresponding to the hollowed out region.

In an exemplary embodiment, a nozzle of the sandblasting apparatus has a diameter ranging from 6 mm to 9 mm, preferably 8 mm.

In an exemplary embodiment, the ink printing unit comprises a screen printing apparatus, the screen printing apparatus has a screen plate, and the screen plate is a polyester screen.

In an exemplary embodiment, the scr een printing apparatus prints the pattern of the UV ink in a one-time printing manner.

In an exemplary embodiment, the pr inted pattern of the UV ink has a thickness ranging from 60 µm to 70 µm.

In another exemplary embodiment, the printed pattern of the UV ink has a thickness ranging from 30 µm to 60 µm.

In an exemplary embodiment, the ink printing unit comprises a charge coupled device (CCD) image positioning apparatus, and the CCD image positioning apparatus is configured to position the screen plate and the solar chip module.

In an exemplary embodiment, the light transmission processing system further comprises a chemical cleaning un it, and the chemical cleaning unit is configured to chemically clean the so lar chip module after the solar chip module is processed by the layer re moving unit to remove the UV ink protective film formed on the solar chip module.

In an exemplary embodiment, a chemical cleaning reagent used in the chemical cleaning unit for removing th e UV ink protective film is KOH or NaOH solution with a concentration (wt %) ranging from 0.3% to 0.5%, and a duration for removing the UV ink pr otective film is 120 seconds to 130 seconds.

In an exemplary embodiment, the ch emical cleaning unit comprises an air drying apparatus.

In an exemplary embodiment, the cu ring unit comprises a UV curing mercury lamp having a light intensity ranging from 800 mJ/cm² to 1500 mJ/cm².

According to a second aspect of the present disclosure, there is provided a light transmission processing method for a solar chip module, the light transmission processing method comprising:
printing a preset pattern on an upper surface of the solar chip module with UV ink so that a UV ink layer is formed on an area of the upper surface of the solar chip module covered by the pattern and a hollowed out region is formed on an area of the upper surface of the solar chip module not covered by the pattern, the solar chip module comprising a transparent substrate and a chip layer, wherein the chip layer is superposed on an upper surface of the transparent substrate;
curing the UV ink printed on the so lar chip module with UV light to form a UV ink protective film; and
removing a portion of the chip layer corresponding to the hollowed out region to expose a portion of the upper surface of the transparent substrate corresponding to the hollowed out region.

In an exemplary embodiment, the step of removing a portion of the chip layer corresponding to the hollowed out region comprises: sandblasting the upper surface of the solar chip module on which the UV ink protective film is formed, so as to remove a portion of the chip layer corresponding to the hollowed out region.

In an exemplary embodiment, bl asting particles used for the sandblasting are white corundum particles having 300 to 350 mesh, a blasting pressure of the sandblasting ranges fr om 3 to 4 bar, and a nozzle of a sandblasting apparatus which performs the sandblasting has a diameter of 8 mm. In an exemplary embodiment, the blasting particles are white corundum particles having 320 mesh.

In an exemplary embodiment, the step of printing a preset pattern on an upper surface of the solar chip module with UV ink comprises: spraying an etchant toward the portion of the upper surface of the solar chip module corresponding to the hollowed out region to remove the portion of the chip layer corresponding to the hollowed out region.

In an exemplary embodiment, after the step of removing a portion of the chip layer corresponding to the hollowed out region, the light transmission processing method further comprises: chemically cleaning the solar chip module to remove the UV ink protective film formed on the solar chip module.

In an exemplary embodiment, a chem ical cleaning reagent used for removing the UV ink protective film is KOH or NaOH solution, a concentration of the KOH solution ranges from 0.3% to 0.5%, a concentration of the NaOH solution ranges from 0.3% to 0.5%, and a duration for removing the UV ink protective film is from 120 seconds to 130 seconds. In addition, a removing temperature for removing the UV ink protective film may be about 30 °C.

In an exemplary embodiment, the step of chemically cleaning the solar chip module to remove the UV ink protective film formed on the solar chip module comprises: air drying the solar chip module that has been cleaned and removed of the film.

In an exemplary embodiment, the step of curing the UV ink printed on the solar chip module with UV light to form a UV ink protective film comprises: curing the UV ink with UV light having a light intensity ranging from 800 mJ/cm² to 1500 mJ/cm², wherein a duration for curing the UV ink ranges from 30 seconds to 90 seconds.

In an exemplary embodiment, in the step of curing the UV ink printed on the solar chip module with UV light to form a UV ink protective film, a distance between a light source of the UV light and an upper surface of the UV ink layer is from 1 mm to 200 mm.

In an exemplary embodiment, the distance between the light source of the UV light and the upper surface of the UV ink layer is from 5 mm to 100 mm.

In an exemplary embodiment, the step of printing a preset pattern on an upper surface of the solar chip module with UV ink comprises: printing the pattern of the UV ink in a one-time printing manner by a screen printing process using a polyester screen as a screen plate, and wherein the printed pattern of the UV ink has a thickness ranging from 60 µm to 70 µm.

In an exemplary embodiment, before the step of printing a preset pattern on an upper surface of the solar chip module with UV ink, the method further comprises: positioning the screen plate and the solar chip module by a CCD image positioning apparatus.

By a combination of ink printing and UV light curing, the light transmission processing system and method for solar chip module provided in the present disclosure can form a UV ink protective film with a desired pattern quickly and accurately. With excellent anti-layer removal property

(i.e., resistance to layer removal) of th e UV ink protective film, it is possible to protect the portion of the chip layer covered by the UV ink protective film from being removed. Therefore, a light transmission processing having a desired light transmission pattern, light transmittance, light transmission effect and light transmission size may be implemented on a chip module quickly and conveniently, and at low cost by the light transmission processing system and method provided in the present disclosure.

### BRIEF DESCRIPTION OF DRAWINGS

Fig. 1 is a schematic sectional view of a chip module to be subjected to light transmission processing;
Fig. 2 is a schematic view of a light transmission processing system for a solar chip module provided in an embodiment of the present disclosure;
Fig. 3 is a schematic sectional view of a chip module printed with a pattern of the UV ink according to an embodiment of the present disclosure;
Fig. 4 is a schematic sectional view of a chip module formed with UV ink protective film according to an embodiment of the present disclosure;
Fig. 5 is a schematic sectional view of a chip module after layer removal according to an embodiment of the present disclosure;
FIG. 6 is a block diagram showing an exemplary structure of an ink printing unit provided in an embodiment of the present disclosure;
FIG. 7 is a block diagram showing an exemplary structure of a layer removing unit provided in an embodiment of the present disclosure;
Fig. 8 is a schematic view of a light transmission processing system for a solar chip module provided in an embodiment of the present disclosure;
Fig. 9 is a schematic sectional view of a chip module after cleaning and film removal according to an embodiment of the present disclosure;
Fig. 10 is a schematic cro ss-sectional view of a lig ht transmissive solar double glass chip module manufactured by the light transmission processing system provided in an embodiment of the present disclosure;
Fig. 11 is a plan view of a standard solar chip module; and
Fig. 12 is a plan view of a light transmissive solar chip module manufactured by the light transmission processing system and method provided in an embodiment of the present disclosure; and
Fig. 13 is a flowchart of a light transmission processing method for a solar chip module according to an embodiment of the present disclosure.

### DETAILED DESCRIPTION

To facilitate those skilled in the ar t to better unders tand the technical solutions of the present disclosure, these technical solutions will now be described in detail in conjunction with the accompanying drawings and embodiments.

It should be understood that in the description of the present disclosure, orientation or positional relationship indicated by terms "upper", "lower", "front", "back", "left", "right", "vertical", "horizontal", "top", "bottom", "inside", "outside" and the like are ba sed on the orientation or positional relationship shown in the drawings, and are merely for an illustrative purpose instead of indicting or implying that the device or component referred to must have a specific orientation or must be configured or operated at a specific orientation, and thus cannot be interpreted as limitations to the present disclosure.

Moreover, terms "first", "second", and the like are used for the purpose of illustration only and should not be construed as indicating or implying a relative importance or implicitly indi eating the number of the indicated technical features. Thus, features defined by "first " or "second" may include one or more of the features either explicitly or implicitly. In the description of the present disclosure, "a plurality" means two or more unless otherwise specified.

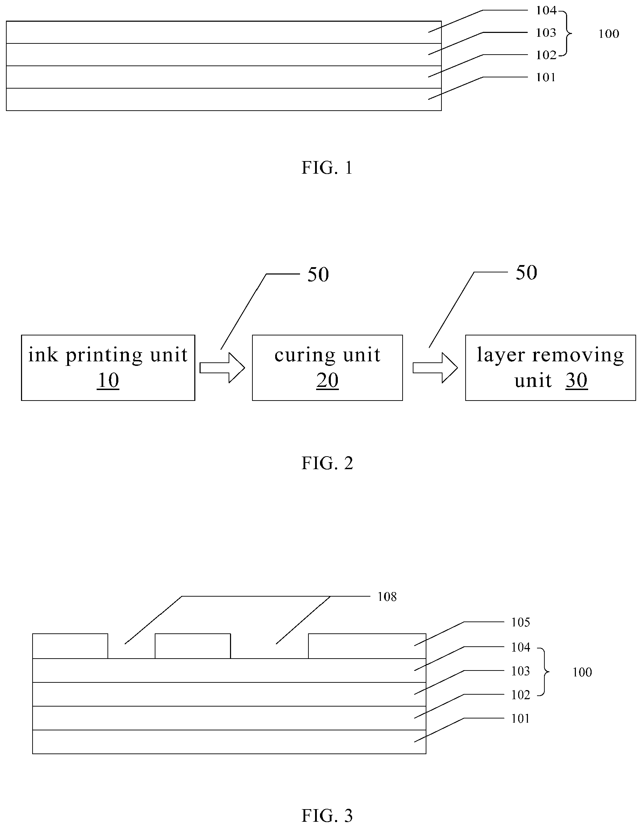

Next, a solar chip module (hereinafter also simply referred to as "chip module") to be subjected to light transmission processing will be described first. Fig. 1 is a schematic sectional view of a chip module to be subjected to light transmission processing. The ch ip module to be subjected to light transmission processing, which may also be referred to as a standard chip module, mainly includes a transparent substrate 101 and a chip layer 100 stacked on an upper surface of the transparent substrate 101. The transparent substrate 101 is typically made of glass (such as tempered glass), but may also be made of other transparent materials such as crystal. The chip layer 100 may also be referred to as a power generation film layer group. Since a solar cell may include various types such as crystalline silicon (including single crystal silicon, polycrystalline silicon), amorphous/monocrystal hetero-junction (HIT), amorphous silicon thin film, cadmi um telluride (CdTe) thin film, and copper indium selenide (CIS) and so on, the chip layer 100 may have various structures, which is not limited herein.

For example, in an alternative embodiment, th e chip layer includes a first layer 102, a second layer 103, and a third layer 104 that are sequentially stacked on the transparent substrate 101. In an alternative example, the first layer 102 is a front electrode layer, the second layer 103 is an absorptive layer, and the third layer 104 is a transparent conductive layer. In another alternative example, the first layer 102 is a molybde num layer, the second layer 103 is a copper indium gallium selenide (CIGS) layer, and the third layer 104 is a transparent conductive oxide (TCO) layer, wherein the CIGS layer 103 is a chalcopyrite crystal thin film layer consisting of Cu (copper), In (indium), Ga (gallium), and Se (selenium), and the TCO layer 104 is a transparent conductive oxide film. In yet another alternative example, the first layer 102 is a ZnO (zinc oxide) front electrode layer, the second layer 103 is a thin film photoelectric conversion layer, and the third layer 104 is a ZnO back electrode layer. In other alternative examples, the number of layers included in the chip layer 100 may be 1, 2, or more than 3. For example, in an alternative example, the chip layer includes a back electrode layer, a light absorptive layer, a TCO window layer, and a gate line electrode layer disposed in sequence. In another alternative example, the chip layer includes: an n-type silicon layer; an n-type amorphous silicon layer and a p-type amorphous silicon layer disposed on two sides of the n-type silicon; transparent conductive layers respectively located at the side of the n-type amorphous silicon layer and the side of the p-type amorphous silicon layer; a back electr ode; and a positive electrode. The chip layer 100 is not light transmissive (is opaque) as a whole. Therefore, the chip module before the light transmission pro cessing is not light transmissive as a whole. Thus, in order to prepare a light transmissive solar chip module with a light transmissive pattern, a part of the chip layer 100 is required to be removed in a preset pattern.

Fig. 2 is a schematic view of a light transmission processing system for a solar chip module provided in an embodiment of the present disclosure. As shown in Fig. 2, the light transmission processing system of the present embodiment includes an ink printing unit 10, a curing unit 20, and a layer removing unit 30.

The ink printing unit 10 is configured to print a preset pattern on an upper surface of the chip module with UV ink so that a UV ink layer 105 is formed on an area of the upper surfa ce of the chip module covered by the pattern, and a hollowed out region 108 is formed on an area of the upper surface of the chip module not cove red by the pattern. The chip module includes a transparent substrate 101 and a chip layer 100 superposed on an upper surface of the transparent substrate 101. A portion of the chip layer 100 corresponding to the hollowed out region 108 is exposed.

Fig. 3 is a schematic sectional view of a chip module printed with a pattern of the UV ink of the embodiment. As shown in Fig. 3, a pattern 105 of the UV ink (UV ink layer) printed by the ink printing unit 10 is placed on the chip layer 100 to cover a portion of the chip layer 100.

The pattern 105 printed on the upper surface of the chip module by the ink printing unit 10 may be in the form of scattered dots, stripes, grids or a variety of other regular or irregular pa tterns, which is not limited herein. In practice, the desired pattern may be designed or selected according to various factors such as architectural aesthetics, or requirements on light transmittance and light transmission effects. In an alternative example, the chip module has a size of 1190 mm × 790 mm, and the pattern 105 of the UV ink may have the same or a slightly smaller size. It will be readily understood by those skilled in the art that the printed pattern of the UV ink is complementary to the pattern finally formed in a light transmissive regi on, while the hollowed out region 108 is consistent with the pa ttern finally form ed in the light transmissive region. For example, if the pattern of the UV ink is a relief text, the pattern finally formed in light transmissive region is an intaglio text complementary to the relief text. It should be understood that when a gate line electrode (not shown) is included in the chip layer 100, the hollowed out region 108 may not be formed at a position corresponding to the region where the gate line electrode is disposed, so as to avoid damages to the gate line electrode during subsequent processings.

The UV ink is also called UV light (ultraviolet light) curing ink, which is an ink containing a photopolymerization prepolymer, an initiator, a colorant, and an adjuvant. Under irradiation of UV light, the photopolymerization prepolymer in the UV ink interacts with the initiator to rapidly dry the ink and form a film.

The inventor has found that the UV ink not only has a good printability, and a suitable curing and drying rate, but also, a protective film (protective layer) formed thereby after being cured by the UV light has an unexpected excellent resistance to layer removal and sandblasting, while the protective film can be easily dissolved by an alkaline solution (e.g., KOH or NaOH solution).

Further, the UV ink may contain a wear-resistant filler such as borax, bentonite, silica and the like.

In an exemplary embodiment, the UV ink used therein is 871 ink or 7315 ink available from KIWO, Inc.

In another exemplary embodiment, the UV ink is prepared in the following manner: spraying a macromolecular prepolymer, a photoinitiator, a crosslinking agent, etc., on the ink layer so that the prepolymer is rapidly polymerized under an action of the photoinitiator.

The curing unit 20 is configured to cure the UV ink printed on the chip module by the UV light to form a UV ink protective film.

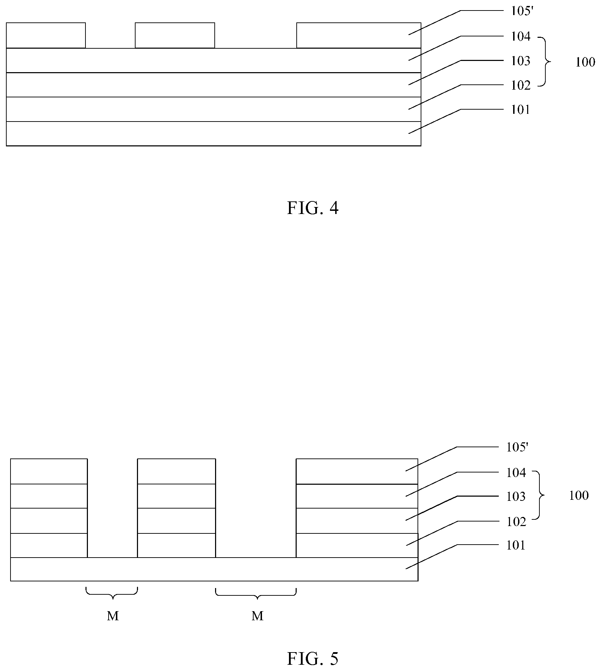

Fig. 4 is a schematic sectional view of a chip module with a formed UV ink protective film 105' according to an embodiment of the present disclosure. After being irradiated and cured by the UV light, the UV ink having the preset pattern 105 on the chip modu le is cured into the UV ink protective film 105' having the same pattern.

The layer removing unit 30 is configured to remove a portion of the chip layer 100 corresponding to the hollowed out region 108 (i.e., a portion of the chip layer 100 that is not covered by the UV ink protective film 105').

Fig. 5 is a schematic sectional view of a chip module after layer removal according to an embodiment of the present disclosure. As shown in Fig. 5, the chip layer 100 at a region M of the chip module that is not covered by the UV ink protective film 105' is remove d by the layer removing unit 30.

Accordingly, a portion of the upper surface of the transparent substrate 101 corresponding to the region M is exposed.

The layer removing unit 30 may empl oy chemical layer removing (e.g., chemical immersion, pickling, etchant spraying), mechanical layer removing (e.g., sandblasting, shot blasting, tumbling), or me chanochemical combined layer removing (e.g., we t blasting containing a chemical reagent) or other layer removing methods for removing the chip layer 100.

By the above processings of the ink printing unit 10, the curing unit 20, and the layer removing unit 30, a light transmissive portion including only the transparent substrate 101 is formed on the region M of the chip module where the chip layer 100 is removed. Thus, a desired light transmissive pattern is formed on the chip module.

With the light transmission processing system provided in the present disclosure, light transmission processing having a desired light transmission pattern, light transmittance, light transmission effect and light transmission size may be implemented on a chip module quickly, conveniently, and at low cost without using an expensive laser etching device. In that, the UV ink protective film 105' can be formed quickly and accurately by a combination of the ink printing unit and the curing unit, and the formed protective film has an unexpected excellent resistance to layer removal, and can protect the portion of the chip layer 100 covered by th e UV ink protective film from being removed, thereby ensuring the product quality of the light transmissive solar chip module.

In an exemplary example of the embodiment, the light transmission processing system for a solar chip module further includes a transmission line 50. The transmission line 50 is configured to sequentially transport the chip module through the ink printing unit 10 , the curing unit 20, and the layer removing unit 30.

The transmission line 50 may be a belt transmission line, a chain transmission line, a robotic transmission line, or the like, which is not limited herein. In an alternative example, as shown in Fig. 2, the transmission line 50 connects the ink printing unit 10 and th e curing unit 20, and connects the curing unit 20 and the layer removing unit 30, respectively. In another alternative example, the transmission line includes an assembly line passing through the ink printing unit 10, the cu ring unit 20 and the layer removing unit 30, and a conveyor device (e.g., ma nipulator) that transports the chip module from the assembly line to resp ective units and from the respective units back to the assembly line. In yet another alternative example, the transmission line 50 is further configur ed to transport th e chip module from the layer removing unit 30 to subsequent units (e.g., a chemical cleaning unit, a packaging unit, etc.) for manufacturing a finished product of the solar chip module. In still another alternative example, the transmission line 50 includes a positioning mechanism that positions the transported chip module.

By providing the transmission line 50, the degree of integration and automation of the light transmission processing system for the solar chip module is improved, labor is saved, and production time is shortened.

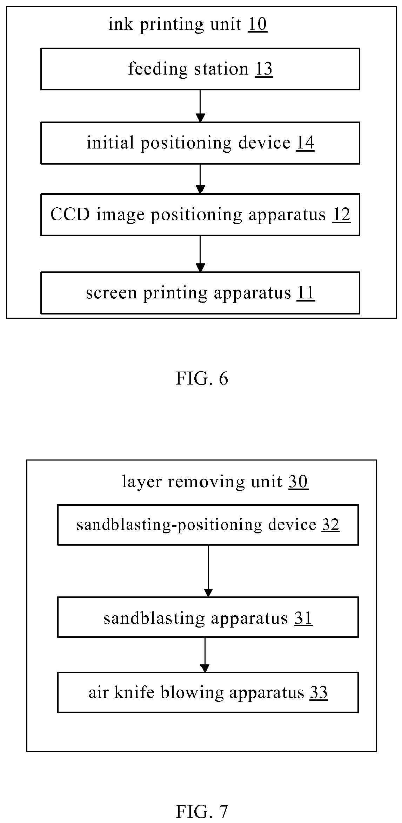

In an exemplary example of the embodiment, as shown in Fig. 6, the ink printing unit 10 includes a screen printing apparatus 11. The screen printing apparatus 11 may use a polyester screen as a screen plate and print the pattern 105 of the UV ink in a one-time printing manner.

In an exemplary example of the embodiment, the polyester mesh has a specification of 140-31Y or 165-34Y.

In an exemplary example of the embodiment, the printed pattern 105 of the UV ink has a thickness ranging from 60 µm to 70 µm.

In another exemplary example of the embodiment, the printed pattern 105 of the UV ink has a thickness ranging from 30 µm to 60 µm.

In an exemplary example of the embodiment, as shown in Fig. 6, the ink printing unit 10 further includes a CCD (Charge Coupled Device) image positioning apparatus 12 configured to po sition the screen plate and the chip module.

The CCD image positioning apparatus is an apparatus for precisely positioning the screen plate and the chip module, or a relative position of the screen plate and the chip module. Th e working principle of the CCD image positioning apparatus is as follows: first, a CCD camera is us ed to obtain an image of an initially positioned chip module, then the obtained image is compared with a pre-stored image, or several reference marks are identified from the obtained image and compared with pre-stored mark position information to calculate a position error, and then a driving member is controlled to move the chip module and/or the screen plate to a predetermined position.

In an example of the embodiment, as shown in Fig. 6, the ink printing unit 10 further includes a feeding station 13 and/or an initial positioning device 14. In an example of the embodiment, the screen printing apparatus 11 includes one or more of the devices consisting of an automatic ink adding device, an ink storage room, a screen plate storage room, a screen plate cleaning room and an associated screen plate cleaning device (not shown). The feeding station 13 is used for transporting the chip module from the transmission line 50 to a work table of the ink printing unit 10. The initial positioning device 14 is used for roughly positioning the chip module with a relatively low precision. In some cases, the function of the initial positioning device may also be realized by the feeding station. The automatic ink adding device automatically adds the require d UV ink to the screen printing apparatus 11. The screen plate cleaning room and the associated screen plate cleaning device are used for cleaning the screen plate after the printing is completed.

By means of the screen printing apparatus 11, the pattern of the UV ink may be printed at one time, and the pr inting process is fast and economical. By means of the CCD image positioning apparatus 12 in cooperation with the screen printing apparatus 11, the desired pattern may be accurately printed.

In an exemplary example of the em bodiment, the curing unit 20 cures the UV ink with UV light having a light intensity ranging from 800 mJ/cm² to 1500 mJ/cm² for a duration of 30 seconds to 90 seconds, wherein the curing unit 20 may include a UV curing mercury lamp serving as a light source for the UV light. The number of the UV cu ring mercury lamps may be three. A distance between the light source of th e UV light and an upp er surface of the UV ink layer 105 may be from 1 mm to 200 mm; and preferably from 5 mm to 100 mm. Further, the curing unit 20 may optionally include a CCD line scanning and detecting system and a transmitting and classifying platform.

It can be seen that un der a suitable light intens ity, a UV ink protective film 105' having sufficient resistance to layer removing may be obtained in only 30 seconds to 90 seconds, which greatly improves the speed of the light transmission process.

In an exemplary example of the embodiment, as shown in Fig. 7, the layer removing unit 30 includes a sandblasting apparatus 31 configured to sandblast an upper surface of the chip module on which the UV ink protective film 105' is formed (i.e., a side where the UV ink protective film 105' is located), so as to remove (spray out) the chip layer 100 at the portion of the chip module that is not covered by the UV ink protective film 105'. Specifically, the sandblasting apparatus 31 sandblasts the chip module (and the UV ink protective film 105' formed thereon) in a direction perpendicular to the surface of the chip module, so that a portio n of the chip layer 100 corresponding to the hollowed out region 108 is removed (from the chip layer 100), while the UV ink protective film 105' is not removed (or is hardly removed) due to the sandblasting resist ance. As a result, a portion of the upper surface of the transparent substrate corresponding to the hollowed out region 108 is exposed through the hollowed out region 108.

In an exemplary example of the embodiment, blasting particles used in the sandblasting apparatus 31 are white corundum particles having 300 to 350 mesh, a blasting pressure ranges from 3 to 4 bar, and a nozzle diameter is 8 mm.

In an exemplary example of the embodiment, as shown in Fig. 7, the layer removing unit 30 includes an air knife blowing apparatus 33 for blowing off impurities on the chip module after the sandblasting (for example, residual white corundum particles, chip layer debris, etc. after the sandblasting).

In an exemplary example of the embodiment, as shown in Fig. 7, the layer removing unit 30 further includes a sandblasting-positioning device 32 for positioning the chip module.

The sandblasting apparatus 31 perfo rms layer removing on the chip layer 100, which process can be properly matched with the physical properties of the UV ink protective film 105' and the chip layer 100 so as to quickly and conveniently remove the exposed por tion of the chip layer 100 without damaging the portion of the chip layer 100 that is covered by the UV ink protective film 105', and which process can accommodate a larger size of the chip module (e.g., 1190 mm × 790 mm).

In some cases, in consideration of package processing, circuit connection, product thickness, and other factor, it is desirable that the UV ink protective film 105' is not included in the final product of the light transmissive solar chip modules.

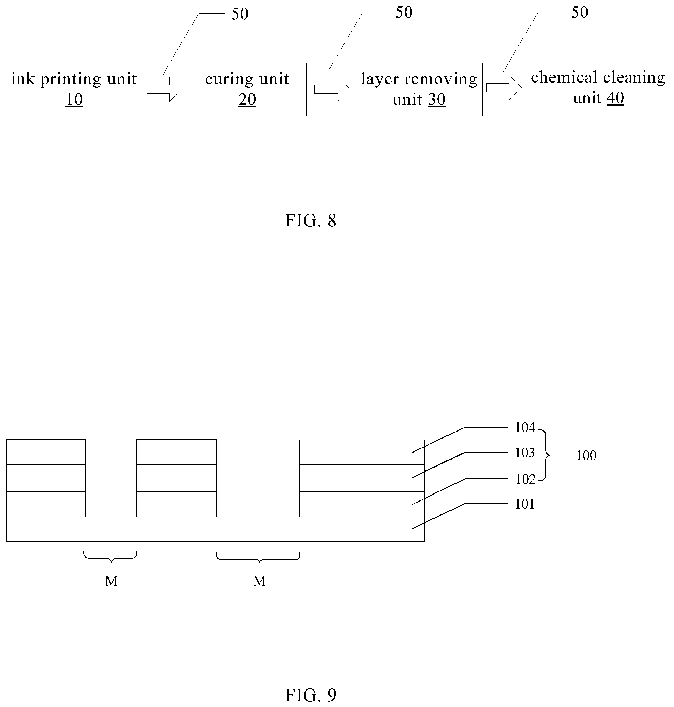

As shown in Fig. 8, in an alternative example of the embodiment, the light transmission processing system fo r a solar chip module further includes a chemical cleaning unit 40 . The chemical cleaning un it 40 is configured to chemically clean the chip module after the solar chip module is processed by the layer removing unit 30 to remove the UV ink protective film 105' formed on the chip module. The structure of the chip module after the UV ink protective film 105' is removed is shown in Fig. 9.

In an exemplary example of the embodiment , a chemical cleaning reagent used in the chemical cleaning unit 40 for removing the UV ink protective film 105' is KOH or NaOH solution with a concentration ranging from 0.3% to 0.5%. In addition, a removing duration for removing the UV ink protective film may be 120 second s to 130 seconds, and a removing temperature may be 30 °C.

In an exemplary example of the embodiment, the chemical cleaning unit 40 includes an air drying apparatus. Th e air drying apparatus is, for example, an air knife apparatus, and the number of air drying apparatus may be one or more.

In an alternative example of the embodiment, the chemical cleaning unit 40 further includes a shower apparatus, a pre-cleaning apparatus, a drug washing apparatus, and so on.

In an alternative example, after be ing sent into the chemical cleaning unit 40 by the transmission line 50, the chip module subjected to layer removing (such as sandblasting) is subjected to pre-cleaning by the pre-cleaning apparatus, wind sweeping by the first air knife apparatus, drug eluting by the drug washing apparatus, wind sweeping by the second air knife apparatus, spray cleaning by the spraying apparatus (in which a conventional cleaning agent such as deionized water may be used), and finally wind sweeping and drying by the third air knife successively.

By providing the chemical cleaning unit 40, not only the UV ink protective film 105' is removed quickly and conveniently and a thickness and weight of the solar chip module are re duced, but also residual impurities on the chip module are removed, thereby ensuring the product quality of the solar chip module. By using KOH or NaOH solution having a concentration of 0.3% to 0.5% as a chemical cleaning reagent (film removing agent), the UV ink can be quickly dissolved and washed thoroughly without reacti ng with the chip layer 100 or the transparent substrate.

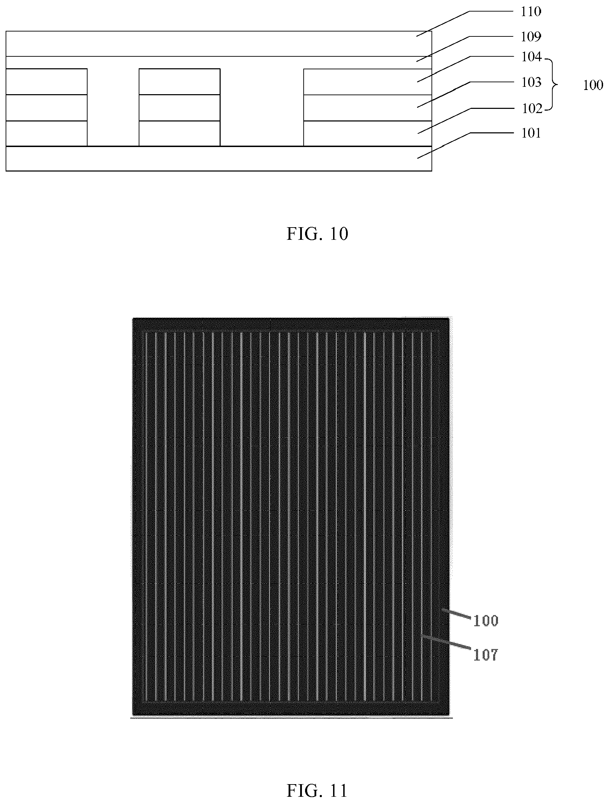

In addition, those skilled in the ar t may understand that the solar chip module may also be pro cessed by subsequent processing units after being subjected to the above described light transmission processing. As shown in Fig. 10, by subsequent processing units, the chip module (see Fig. 9) that has been subjected to the light transmission processing may be packaged to form a package layer 109 on the upper surface of the chip module, and a transparent substrate 110 as a back plate may be bonded onto an upper surface of the packaged chip module, thereby forming a light transmissive solar double glass chip module (for example, a CIGS double glass module) having a light transmissive pattern. These subsequent processing units and corresponding processing methods thereof are similar to existing processing units and processing methods for solar chip modules, and will not be described in detail herein.

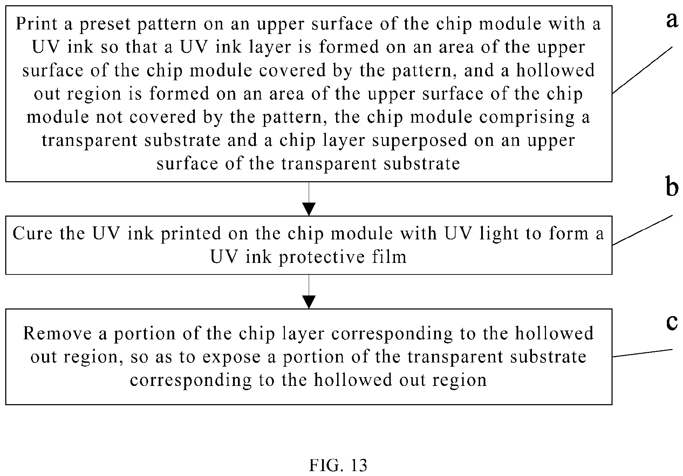

In addition, an embodiment of the pr esent disclosure further provides a light transmission processing method fo r a solar chip module. As shown in Fig. 13, the light transmission processing method includes the steps of:
step *a*: printing a preset pattern on an upper surface of the chip module with UV ink so that a UV ink layer is formed on an area of the upper surface of the chip module covered by the pattern, and a hollowed out region is formed on an area of the upper surface of the chip module not covered by the pattern, the chip module comprising a transparent substrate and a chip layer superposed on an upper surface of the transparent substrate;
step *b*: curing the UV ink printed on the chip module with UV light to form a UV ink protective film; and
step *c*: removing a portion of the chip layer corresponding to the hollowed out region to expose a portion of the upper surface of the transparent substrate corresponding to the hollowed out region.

In an exemplary example of the embodiment, the step *c* comprises: sandblasting the upper surface of the chip module on which the UV ink protective film is formed to remove a portion of the chip layer corresponding to the hollowed out region.

In an exemplary example of the embodiment, the blasting particles used in the sandblasting are white corundum particles, silicon carbides or steel shots.

In an exemplary example of the embodiment, blasting particles used for the sandblasting are white corundum particles having 300 to 350 mesh, a blasting pressure of the sandblasting ranges from 3 to 4 bar, and a nozzle of the sandblasting apparatus 31 which performs the sandblasting has a diameter of 8 mm.

In an exemplary example of the embodiment, the step *c* comprises: spraying an etchant toward the portion of the upper surface of the chip module corresponding to the hollowed out region to remove the portion of the chip layer corresponding to the hollowed out region.

It should be understood that the composition of the etchant is determined according to the composition of the chip layer and the type of UV ink, that is, the selected etchant can effectively etch the chip layer, but not the UV ink protective film.

In an exemplary example of the embodiment, after the step *c*, the light transmission processing method further comprises: chemically cleaning the chip module to remove the UV ink protective film formed on the chip module.

In an exemplary example of the embodiment , a chemical cleaning reagent used for removing the UV ink protective film is KOH or NaOH solution with a concentration ranging fr om 0.3% to 0.5%, and a duration for removing the UV ink protective film is 120 seconds to 130 seconds.

In an exemplary example of the em bodiment, the step of chemically cleaning the chip module to remove the UV ink protective film formed on the chip module comprises: air drying the chip module that has been cleaned and removed of the film.

In an exemplary example of the embodiment, the step *b* comprises: curing the UV ink (UV ink layer) with UV light having a light intensity ranging from 800 mJ/cm² to 1500 mJ/cm² for a duration of 30 seconds to 90 seconds. Further, optionally, a distan ce between the light source of the UV light and the upper surface of the UV ink layer is from 1 mm to 200 mm; and preferably from 5 mm to 100 mm.

In an exemplary example of the embodiment, the step *a* comprises: printing the pattern of the UV ink in a one-time printing manner by a screen printing process using a polyester screen as a screen plate, and wherein the printed pattern of the UV ink has a thickness ranging from 60 µm to 70 µm.

In an exemplary example of the embodiment, before the step *a*, the light transmission processing method further comprises: positioning a relative position the screen plate and the chip module by a CC D image positioning apparatus.

In an exemplary example of the embodiment, after cleaning and removing the UV ink protective film, the obtained chip module is packaged, and a transparent substrate as a back plate is bonded onto an upper surface of the packaged chip module, so as to form a light transmissive solar double glass chip module (for example, a CIGS double glass module) having a light transmissive pattern.

Light transmission processing having a desired light transmission pattern, light transmittance, light transmission effect and light transmission size may be implemented on a chip module quickly, conveniently, and at low cost by the light transmission processing method provide d in the present disclosure. In that, a UV ink is used to print a preset pattern on the upper surface of the chip module and is cured by UV light. As a result, a UV ink protective film can be formed quickly and accurately, and the formed protective film has an unexpected excellent resistance to layer removal, and can protect the chip layer covered by the protective film from being removed, thereby ensuring the quality of the manufactured solar chip module. Layer removal by sandblasting can be properly matched with the physical properties of the UV ink protective film and the chip layer so as to quickly and conveniently remove the exposed portion of the chip layer without damaging the portion of the chip layer that is covered by the UV ink protective film, and can accommodate a larger size of the chip module (e.g., 1190 mm × 790 mm). By chemically cleaning the chip module after the layer removal, not only the UV ink protective film is removed quick ly and conveniently and a thickness and weight of the solar chip module are reduced, but also residual impurities on the chip module are removed, thereby ensuring the product quality of the solar chip module.

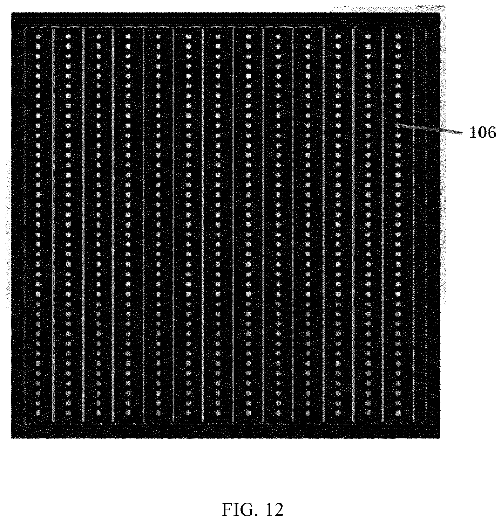

Fig. 11 is a schematic plan view of a standard solar chip module, which schematically shows the chip layer 100 of a standard solar chip module and a scribe line 107 on the upper surface of the chip layer. Fig. 12 shows a schematic plan view of a solar chip module manufactured according to various embodiments of the present disclosure. It can be seen that the manufactured light transmissive solar chip module has a regularly arranged dots-like light transmissive pattern 106.

It should be understood that the above embodiments and exemplary/optional examples thereof are merely exemplary implementations for the purpose of illustrating the principle of the present disclosure, and the present disclosure is not limited thereto. Various modifications and improvements can be made by a person having ordinary skill in the art without departing from the spirit and essence of the present disclosure. Accordingly, all of the modifications and improvement s also fall into the protection scope of the present disclosure.

## Claims

1. A light transmission processing sy stem for processing a solar chip module, comprising:
an ink printing unit (10) configured to print a preset pattern on an upper surface of the solar chip module with an ultraviolet ink, called a UV ink, so that a UV ink layer (105) is formed on an area of the upper surface of the solar chip module covered by the pattern, and a hollowed out region (108) is formed on an area of the upper surface of the solar chip module not covered by the pattern, wherein the solar chip module comprises a transparent substrate (101) and a chip layer (100), and the chip layer (10) is superposed on an upper surface of the transparent substrate (101);
a curing unit (20) configured to cure the UV ink printed on the solar chip module with UV light to form a UV ink protective film (105'); and
a layer removing unit (30) configured to remove a portion of the chip layer (100) corresponding to the hol lowed out region (108) to expose a portion of the upper surface of the transparent substrate (101) corresponding to the hollowed out region (108).

2. The light transmission processing system according to claim 1, wherein the light transmission processing system further comprises a transmission line (50), and the transmission line (50) is configured to transport the solar chip module through the ink printing unit (10), the curing unit (20), and the layer removing unit (30) sequentially.

3. The light transmission processing system according to claim 1, wherein the layer removing unit (30) comprises a sandblasting apparatus (31), and the sandblasting apparatus (31) is configured to sandblast the upper surface of the solar chip module on which the UV ink protective film (105') is formed to remove the portion of the chip layer (100) corresponding to the hollowed out region (108).

4. The light transmission processing system according to any one of claims 1 to 3, wherein the ink printing unit (10) comprises a screen printing apparatus (11), the screen printing apparatus (11) has a screen plate, and the screen plate is a polyester screen.

5. The light transmission processing system according to claim 4, wherein the ink printing unit (10) further comprises a charge coupled device image positioning apparatus, called a CCD image positioning apparatus (12), and the CCD image positioning apparatus (12) is configured to position the screen plate and the solar chip module.

6. The light transmission processing system according to any one of claims 1 to 3, wherein the light transmission processing system further comprises a chemical cleaning unit (40), and the chemical cleaning unit (40) is configured to chemically clean the solar chip module after the solar chip module is processed by the layer removing unit (30) to remove the UV ink protective film (105') formed on the solar chip module.

7. A light transmission processing method for a solar chip module, comprising:
printing (step a) a preset pattern on an upper surface of the solar chip module with UV ink so that a UV ink layer (105) is formed on an area of the upper surface of the solar chip module covered by the pattern, and a hollowed out region (108) is formed on an area of the upper surface of the solar chip module not covered by the pattern, th e solar chip module comprising a transparent substrate (101) and a chip layer (100), wherein the chip layer is superposed on an upper surface of the transparent substrate (101);
curing (step b) the UV ink printed on the solar chip module with UV light to form a UV ink protective film (105'); and
removing (step c) a portion of the chip layer (100) corresponding to the hollowed out region (108) to expose a portion of the upper surface of the transparent substrate (101) corresponding to the hollowed out region (108).

8. The light transmission processing method according to claim 7, wherein the step of removing a portion of the chip layer corresponding to the hollowed out region comprises:
sandblasting the upper surface of th e solar chip module on which the UV ink protective film (105') is formed, so as to remove a portion of the chip layer (100) corresponding to the hollowed out region (108).

9. The light transmission processing method according to claim 8, wherein blasting particles used for the sandblasting are white corundum particles having 300 mesh to 350 mesh, a blasting pressure of the sandblasting ranges from 3 bar to 4 bar, and a nozzle of a sandblasting apparatus (31) which performs the sandblasting has a diameter of 8 mm.

10. The light transmission processing method according to any one of claims 7 to 9, wherein the step of printing a preset pattern on an upper surface of the solar chip module with UV ink comprises:
printing the pattern of the UV ink in a one-time printing manner by a screen printing process using a polyester screen as a screen plate, and wherein the printed pattern of the UV ink has a thickness ranging from 60 µm to 70 µm or from 30 µm to 60 µm.

11. The light transmission processing method according to claim 10, wherein before the step of printing a preset pattern on an upper surface of the solar chip module with UV ink, the light transmission processing method further comprises:
positioning the screen plate and the solar chip module by a CCD image positioning apparatus (12).

12. The light transmission processing method according to any one of claims 7 to 9, wherein after the step of removing a portion of the chip layer corresponding to the hollowed out region, the light transmission processing method further comprises:
chemically cleaning the solar chip module to remove the UV ink protective film (105') formed on the solar chip module.

13. The light transmission processing method according to claim 12, wherein a chemical cleaning reagent used for removing the UV ink protective film (105') is KOH or NaOH solution, a concentration of the KOH solution ranges from 0.3% to 0.5%, a concentration of the NaOH solution ranges from 0.3% to 0.5%, and a duration for removing the UV ink protective film (105') is 120 seconds to 130 seconds.

14. The light transmission processing method according to any one of claims 7 to 9, wherein the step of curing the UV ink printed on the solar chip module with UV light comprises:
curing the UV ink with UV light having a light intensity ranging from 800 mJ/cm² to 1500 mJ/cm², wherein a duration for curing the UV ink ranges from 30 seconds to 90 seconds.

15. The light transmission processing method according to claim 7, wherein the step of removing a portion of the chip layer corresponding to the hollowed out region further comprises:
spraying an etchant toward the portio n of the upper surface of the solar chip module corresponding to the hollowed out region (108) to remove the portion of the chip layer (100) corres ponding to the hollowed out region (108).
